# EUROPEAN PATENT APPLICATION

(11) **EP 3 040 730 A2**
(43) Date of publication of application: **06.07.2016**
(21) Application number: 15185743.0
(22) Date of filing: 17.09.2015
(51) Int. Cl.: G01R 31/3187, G06F 11/00, G01R 31/3183

(54) **APPARATUS FOR TESTING SEMICONDUCTOR CHIP HAVING BUILT-IN SELF TEST FUNCTION**

(30) Priority: 30.12.2014 KR 20140192789
(71) Applicant: iA, Inc., Seoul (KR)
(72) Inventor: BAE, Jungyang, Yongin-si, Gyeonggi-do (KR)
(74) Representative: Schumacher & Willsau

(57) **Abstract**

The present invention relates to an apparatus for testing a semiconductor chip in which a built-in self test function is embedded, the apparatus including a plurality of error generators inserted between a plurality of function blocks performing a function of the semiconductor chip to input an error signal into the function blocks; and an external error controller for controlling the error generators through external input and output pins of the semiconductor chip and confirming the built-in self test function of the semiconductor chip by monitoring an output signal of the function blocks, and thus an error detection function embedded in the semiconductor chip can be correctly verified.

## Description

### BACKGROUND OF THE INVENTION

### Field of the Invention

The present invention relates to an apparatus for testing a semiconductor chip, and more specifically, to an apparatus for testing a semiconductor chip, which can test a built-in self test function embedded in the semiconductor chip.

### Background of the Related Art

As degrees of integration and complexity in a circuit such as a semiconductor chip abruptly increase, a method of testing or diagnosing a completed product also becomes more complex. Various testing methods for determining whether or not a produced product normally operates are provided, and a built-in self test (BIST) method including a test function inside thereof is also frequently used.

Generally, testing a malfunction at an external pin of a semiconductor chip is performed by generating a direct connection error, and a CPU or memory is used to test operation of a fault detection function provided inside the chip.

For example, a method of damaging a value in the memory or damaging a value of a CPU register (write an arbitrary value) using a CPU debugging function (JTAG: Joint Test Action Group) on the assumption that an operation error occurs inside the chip and confirming restoration of software or transition to a fault response mode is used. In addition, a method of creating a function for generating an error in each of major blocks, executing an error generation scenario at an arbitrary time by the CPU using a program, and confirming malfunctions and a prepared response action of the chip according thereto is used.

Korean Patent Registration No. 10-0267096 proposes a method capable of scanning either a single scan chain or all parallel scan chains selected to be used in a JTAG environment for the purpose of debugging an integrated circuit chip.

However, whether or not the built-in self test embedded in a semiconductor chip normally operates cannot be correctly confirmed only through a simulation using the CPU debugging function or the like as described above. That is, it is difficult to completely verify an error detection function of a semiconductor chip by an indirect test performed through a simulation as described above.

It may be sufficient to use only a test method performed through a simulation as described above in the case of an apparatus or a system which is not related to safety. However, if a fault occurs in a semiconductor chip used in a vehicle, a train, an airplane or the like and an abnormal signal is output, it may cause irrevocable damage.

Accordingly, development of a test apparatus which can test further securely whether or not a fault detection function embedded in a semiconductor chip normally operates is earnestly required.

### SUMMARY OF THE INVENTION

Accordingly, the present invention is made in view of the above-mentioned problems occurring in the prior art, and it is an object of the present invention to provide a test apparatus capable of correctly verifying an error detection function embedded in a semiconductor chip.

To accomplish the above object, according to an aspect of the present invention, there is provided an apparatus for testing a semiconductor chip in which a built-in self test function is embedded, the apparatus including: a plurality of error generators inserted between a plurality of function blocks performing a function of the semiconductor chip to input an error signal into the function blocks; and an external error controller for controlling the error generators through external input and output pins of the semiconductor chip and confirming the built-in self test function of the semiconductor chip by monitoring output signals of the function blocks.

The error generator includes: a control unit for receiving a first error control signal from the external error controller and determining whether or not to cause the error generator to be operated; an error code reception unit for receiving a second error control signal from the external error controller and transmitting, to the control unit, an error code signal, which is information relating to an error pattern to be generated by the error generator; an error pattern storage unit for storing a plurality error patterns, receiving the error code signal from the control unit and outputting an error pattern corresponding to an error code; and an output selection unit for outputting either a function signal from the function block or an error pattern signal from the error pattern storage unit according to a selection signal from the control unit.

The second error control signal from the external error controller includes an error code signal, a clock signal and an effective signal, and the error code reception unit includes: a plurality of error code storage units for receiving and storing the error code signal in synchronization with the clock signal; and an effective signal determination unit for determining effectiveness of the error code signal and causing only effective error codes to be stored in the error code storage units.

The error code storage units are preferably connected to each other in a series, and the error code signal is transferred in a manner of shifting, and the error code reception unit is connected to an error code reception unit of another error generator in a series, and the error code signal is transferred in the manner of the shifting.

### BRIEF DESCRIPTION OF THE DRAWINGS

FIG. 1 is a block diagram showing a connection structure between internal function blocks of a semiconductor chip.
FIG. 2 is a block diagram showing the configuration of an apparatus for testing a semiconductor chip according to an embodiment of the present invention.
FIG. 3 is a block diagram showing the function of an error generator according to an embodiment of the present invention.
FIG. 4 is a block diagram showing the function of an error code reception unit according to an embodiment of the present invention.

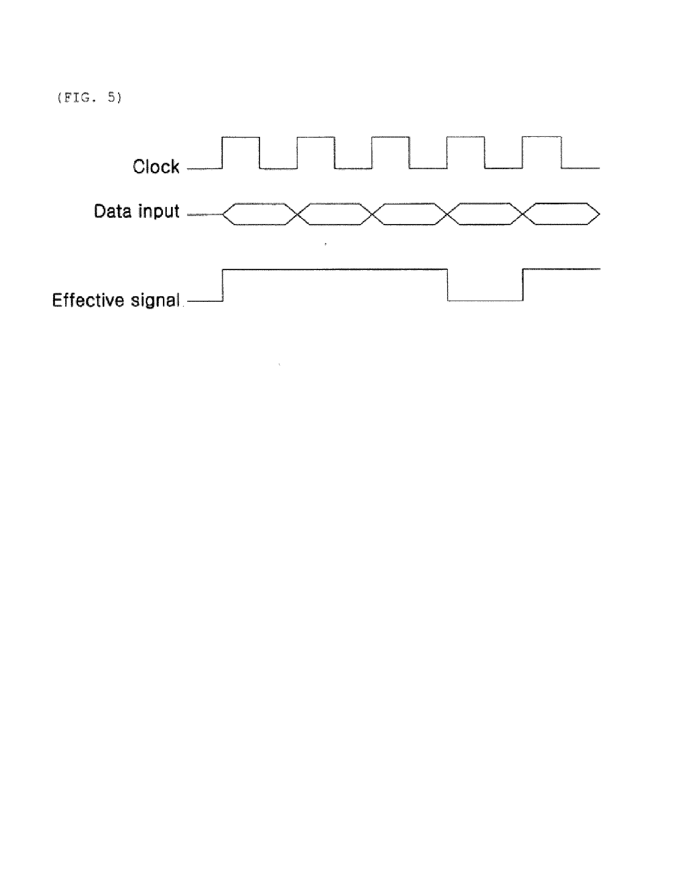

FIG. 5 is a waveform diagram showing timing of an input signal of an error code reception unit according to an embodiment of the present invention.

### DESCRIPTION OF SYMBOLS

| | | | |
|---|---|---|---|
| 100: | Semiconductor chip | 200: | External error controller |
| 300: | Error generator | 310: | Control unit |
| 320: | Error code reception unit | | |
| 321, 322, 323: | Error code storage unit | | |
| 324: | Effective signal determination unit | | |
| 330: | Error pattern storage unit | 340: | Output selection unit |

### DETAILED DESCRIPTION OF THE PREFERRED EMBODIMENT

Hereinafter, a preferred embodiment of the present invention will be described with reference to the attached drawings.

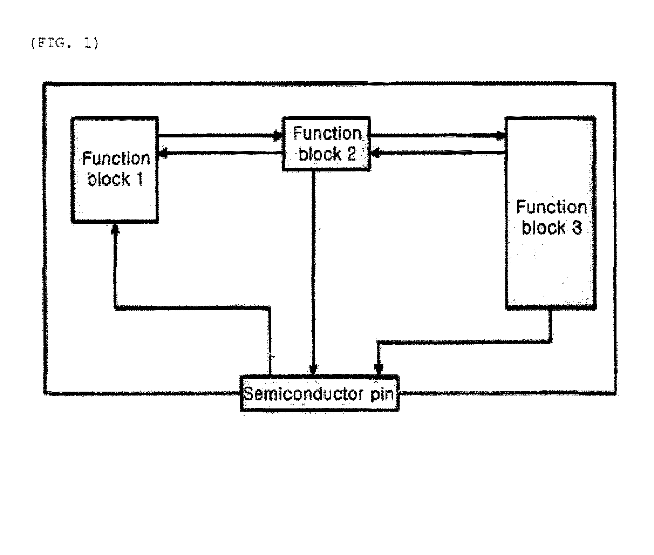

Although a defect may be generated in a basic element (transistor/wire) of a semiconductor, generating a defect in each element and preparing a circuit for generating the defect in a semiconductor configured of some hundreds of thousands or millions of circuits is inefficient from the aspect of a limited size and commercialization. Accordingly, when a semiconductor is designed, it is designed to be divided into function blocks of an appropriate unit, and the blocks are connected using signal lines. An example of this is shown in FIG. 1.

Although an error may occur at a certain part inside of each function block, the effect of generating the error influences output of each block, and the error is transferred to a final output of the semiconductor chip (a pin of the chip) and influences the outside (system). That is, since an error occurs inside a unit block and gives an effect between blocks or influences an external connection unit of the semiconductor chip, generating a defect and providing the defect to a connection signal between blocks to modify the signal can be an efficient error verification method.

According to this point of view, in the present invention, an error generator is attached at the input and output terminals of each function to actively generate a fault through the error generator so that a built-in self test function of a semiconductor can be completely verified.

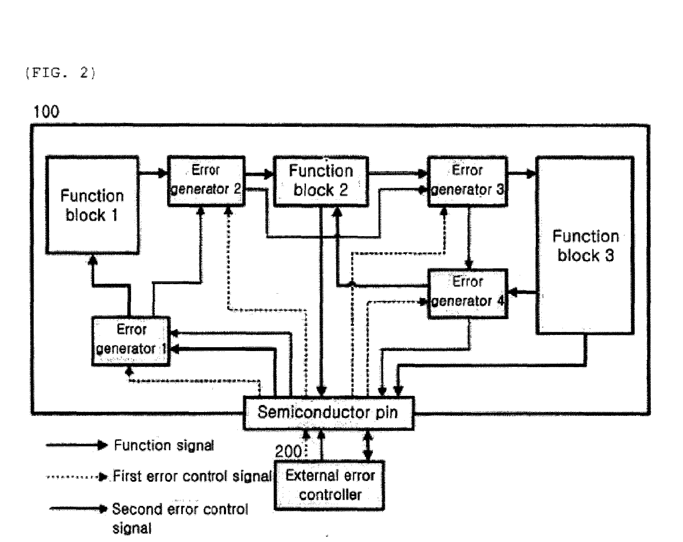

FIG. 2 is a block diagram showing the configuration of a semiconductor chip in which a test circuit of a built-in self test function is embedded according to an embodiment of the present invention.

As shown in FIG. 2, a semiconductor chip 100 in which a test circuit of a built-in self test function of the present invention is embedded is configured such that an error generator 300 is inserted between function blocks. Each error generator 300 inputs a previously stored error signal into a function block, and an external error controller 200 receives an output signal of the function block and confirms whether or not the built-in self test function of semiconductor chip 100 normally operates. In FIG. 2, a first error control signal is a control signal for turning on/off each error generator, which is transmitted through an individual line connected to each error generator. Contrarily, a second error signal is a signal for transmitting an error code, which is input into each error generator by shifting.

The external error controller 200 is configured to select an error pattern which the error generators input into a function block. Accordingly, a variety of predetermined error tests can be selectively performed outside the semiconductor chip 100.

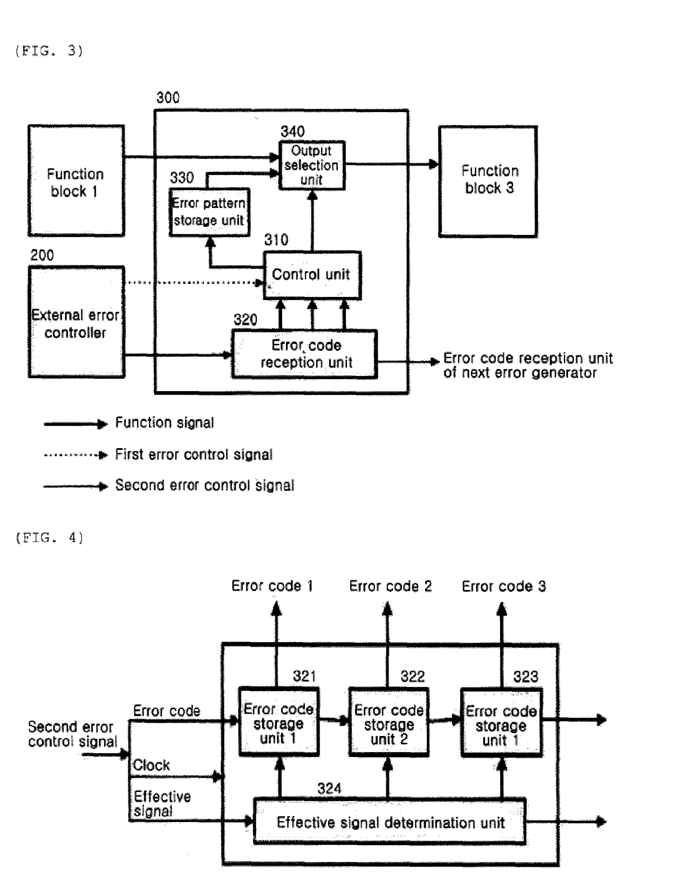

FIG. 3 is a block diagram showing the configuration of an error generator. As shown in FIG. 3, the error generator 300 is configured to include a control unit 310, an error code reception unit 320, an error pattern storage unit 330 and an output selection unit 340.

First, the control unit 310 determines whether or not to operate the error generator 300 according to a first error control signal from the external error controller 200. That is, as is understood from FIG. 2, the first error control signal is input into each error generator 300 through a separate signal line, and thus, the control unit 310 can control to determine whether or not to cause the error generator 300 to be operated so as to input an error signal into a function block. Like this, since activation or deactivation of the error generator 300 can be individually controlled from outside, a time point of testing the semiconductor chip 100 and a function block desired to be tested can be selectively determined.

If the error generator 300 is activated by the control unit 310, the error code reception unit 320 receives a second error control signal from the external error controller 200. The second error control signal is configured of an error code signal, a clock signal and an effective signal as shown in FIG. 4, and the effective signal is a signal for verifying reception of the error code signal.

As shown in FIG. 4, the error code reception unit 320 is configured of a plurality of error code storage units 321, 322 and 323 for receiving and storing an error code signal in synchronization with the clock signal and an effective signal determination unit 324 for determining effectiveness of the error code signal and storing only effective error code signals in the error code storage units. Although three error code storage units 321, 322 and 323 are exemplified in this embodiment, further more number of error code storage units may be installed as needed.

The error code storage units 321, 322 and 323 are consecutively connected in series in order to input and output an error code signal in the manner of shifting. An output of the final error code storage unit 323 is input into the error code reception unit of a next error generator. That is, the error code reception units of all the error generators 300 embedded in the semiconductor chip 100 are connected to each other in series and transfer an error code signal input from the external error generator 200 by shifting the error code signal.

The effective signal determination unit 324 determines whether or not the input error code signal is effective on the basis of the effective signal of the second error control signal and inputs only effective error codes into the error code storage units 321, 322 and 323. That is, since the error code signal is input by shifting, the effective signal determination unit 324 performs a function of identifying the start and the end of the input error code signal using the effective signal.

The error codes output from the error code storage units 321, 322 and 323 are input into the control unit 310. The control unit 310 sends the error code to the error pattern storage unit 330, and the error pattern storage unit 330 outputs an error pattern corresponding to the error code. The error pattern storage unit 330 stores a plurality of error patterns in advance and outputs a stored error pattern according to the error code input from the control unit so that the error pattern may be input into the output selection unit 340.

An error pattern stored in the error pattern storage unit 330 is stored in the manner of a scenario which is set in advance when the apparatus is designed. For example, in the case of a digital signal, since a normal signal has two types of values of High (1)/Low (0) and moves as a combination of these two signals, if 1 (fixed)/ 0 (fixed)/ disconnection/ soft error (instantaneous contamination of a signal (pulse form)) or the like is input as an error code, a predefined error pattern is output according thereto.

The output selection unit 340 selects either a function signal (a normal operation signal) from function block 1 or an error pattern signal (an abnormal operation signal) from the error pattern storage unit 330 according to a selection signal received from the control unit 310 and outputs the selected signal to function block 3. That is, a normal signal is output from the output selection unit 340 if the error generator 300 is in an inactive state, and a predetermined error signal is output if the error generator 300 is in an active state, so that an error may occur in a connection value between function blocks.

According an embodiment of the present invention, since various error patterns can be selectively applied to a function block by inputting an error code from outside of a semiconductor chip 100, a built-in self test function of the semiconductor chip can be tested while changing the error patterns. Accordingly, the semiconductor chip can be tested by applying a variety of test scenarios.

The test apparatus of the present invention has following effects.

First, an error detecting function in a semiconductor chip can be verified in detail.

Second, since a scenario and a time point for detecting an error can be changed from outside of a semiconductor chip, verification can be performed more effectively and efficiently.

Third, since an error data is transmitted to an error generator embedded in a semiconductor chip by shifting the error data in series, complexity can be minimized by simplifying the structure of a circuit for testing an error.

Fourth, since a signal is input and output to and from an external error controller using a serial interface, the number of connection pins of a semiconductor chip can be minimized.

While the present invention has been described with reference to the particular illustrative embodiments, it is not to be restricted by the embodiments but only by the appended claims. It is to be appreciated that those skilled in the art can change or modify the embodiments without departing from the scope and spirit of the present invention.

## Claims

1. An apparatus for testing a semiconductor chip in which a built-in self test function is embedded, the apparatus comprising:
a plurality of error generators inserted between a plurality of function blocks performing a function of the semiconductor chip to input an error signal into the function blocks; and
an external error controller for controlling the error generators through external input and output pins of the semiconductor chip and confirming the built-in self test function of the semiconductor chip by monitoring output signals of the function blocks.

2. The apparatus according to claim 1, wherein the error generator includes:
a control unit for receiving a first error control signal from the external error controller and determining whether or not to cause the error generator to be operated;
an error code reception unit for receiving a second error control signal from the external error controller and transmitting, to the control unit, an error code signal, which is information relating to an error pattern to be generated by the error generator;
an error pattern storage unit for storing a plurality error patterns, receiving the error code signal from the control unit and outputting an error pattern corresponding to an error code; and
an output selection unit for outputting either a function signal from the function block or an error pattern signal from the error pattern storage unit according to a selection signal from the control unit.

3. The apparatus according to claim 2, wherein the second error control signal from the external error controller includes an error code signal, a clock signal and an effective signal.

4. The apparatus according to claim 3, wherein the error code reception unit includes:
a plurality of error code storage units for receiving and storing the error code signal in synchronization with the clock signal; and
an effective signal determination unit for determining effectiveness of the error code signal and causing only effective error codes to be stored in the error code storage units.

5. The apparatus according to claim 4, wherein the error code storage units are connected to each other in a series, and the error code signal is transferred in a manner of shifting.

6. The apparatus according to claim 5, wherein the error code reception unit is connected to an error code reception unit of another error generator in a series, and the error code signal is transferred in the manner of the shifting.
